**Europäisches Patentamt**

**European Patent Office**

**Office européen des brevets**

(19)

(11) Veröffentlichungsnummer: **0 035 180 A2**

(12) **EUROPÄISCHE PATENTANMELDUNG**

(21) Anmeldenummer: 81101192.3

(22) Anmeldetag 19.02.81

(51) Int. Cl.³: **H 03 H 11/48**

(30) Priorität: 29.02.80 DE 3007791

(43) Veröffentlichungstag der Anmeldung: **09.09.81**
**Patentblatt 81/36**

(84) Benannte Vertragsstaaten: **AT BE CH DE FR GB IT LI LU NL SE**

(71) Anmelder: **SIEMENS AKTIENGESELLSCHAFT Berlin und München, Postfach 22 02 61, D-8000 München 22 (DE)**

(72) Erfinder: **von Pfeil, Dirsko, Ing. grad., Dammstrasse 14, D-8021 Hohenschäftlarn (DE)**
Erfinder: **Ullmann, Helga, Guardinistrasse 73, D-8000 München 70 (DE)**

(54) Schaltungsanordnung zur Erhöhung der Induktivität eines Übertragers.

(57) Die Erfindung betrifft eine Schaltungsanordnung zur Erhöhung der Induktivität eines Übertragers. Zu einer Wicklung eines Übertragers (UE) wird eine negative Induktivität parallel geschaltet. Durch die hieraus resultierende größere Induktivität können wesentliche kleinere Bauformen von Übertragern verwendet werden. Die negative Induktivität wird durch einen spulenfreien Negativimpedanzkonverter (NIC) erzeugt. In einem Ausführungsbeispiel ist die Erfindung in einem Speiseübertrager einer Teilnehmerschaltung eingesetzt.

SIEMENS AKTIENGESELLSAFT

Berlin und München

0035180

Unser Zeichen

VPA    80 P 6536 E

Schaltungsanordnung zur Erhöhung der Induktivität eines Übertragers

Die Erfindung betrifft eine Schaltungsanordnung zur Erhöhung der Wicklungsinduktivitäten eines Übertragers.

In elektronischen Schaltungen mit Übertragern wird von diesen eine bestimmte Mindestinduktivität gefordert. Weitere den Übertrager betreffende Forderungen sind beispielsweise der maximal zulässige Gleichstromwiderstand der Wicklung und die zulässige Gleichstromvormagnetisierung des Übertragerkernes.

Aus diesen Forderungen ergibt sich oft ein relativ großer und entsprechend teuerer Übertrager, der zumeist als größtes Bauelement auf einer Schaltungsbaugruppe den Abstand der Baugruppen zueinander bestimmt.

In dem Buch "Halbleiter-Schaltungstechnik", von U.Tietze und C.Schenk, Springer-Verlag, sind aktive Schaltungen mit Gyratoren zur Nachbildung von Induktivitäten angegeben.

Mit diesen Schaltungen läßt sich jedoch die Induktivität eines zur Potentialtrennung dienenden Übertragers nicht ohne weiteres erhöhen.

Wegen ihres Eigenrauschens und einer probematischen Stromversorgung der angeschlossenen Baugruppe über eine Übertragerwicklung sind diese Schaltungen nicht für die Lösung dieses Problems geeignet.

Aufgabe der Erfindung ist es, eine Schaltungsanordnung anzugeben, die die Verwendung kleinerer Übertrager mit

P 1 Toi / 29.02.1980

0035180

kleineren Wicklungsinduktivitäten ermöglicht.

Die Aufgabe wird erfindungsgemäß dadurch gelöst, daß parallel zu einer Wicklung eines Übertragers eine negative Induktivität geschaltet ist.

Vorteile der Erfindung ergeben sich durch die Verkleinerung des Übertragers. Hierdurch wird nicht nur eine Platzersparnis erzielt, durch das geringe Gewicht des Übertragers ergeben sich zusätzlich weitere konstruktive Vorteile. Durch die Verwendung kleinerer Übertrager werden außerdem Preisvorteile erzielt.

Da kleinere Übertrager mit einer geringeren Windungsanzahl je Wicklung verwendet werden können, ergibt sich ein kleinerer Gleichstromwiderstand, damit eine geringere Dämpfung des Übertragers und bei einer Stromversorgung über eine Übertragungswicklung auch eine geringere Gleichstormvormagnetisierung.

Vorteilhaft ist es, wenn parallel zu einer Wicklung des Übertragers als negative Induktivität ein Negativ-Impedanzkonverter geschaltet ist.

Für einen Negativ-Impedanzkonverter wird nur ein einziger mit wenigen passiven Bauelementen beschalteter Operationsverstärker benötigt.

Es ist weiterhin vorteilhaft, wenn ein Negativ-Impedanzkonverter vorgesehen ist, dessen Eingang auf den nichtinvertierenden Eingang eines Verstärkers geführt ist, daß der Ausgang des Verstärkers über einen ersten ohmschen Widerstand mit seinem nichtinvertierenden Eingang verbunden ist und über eine Parallelschaltung eines Kondensators und eines zweiten ohmschen Widerstandes mit seinem invertierenden Eingang verbunden ist und daß der invertierende Eingang über einen dritten ohmschen Widerstand an ein Bezugspotential (Masse) geschaltet ist.

Bei dieser Weiterbildung der Erfindung werden außer einem Operationsverstärker nur drei Widerstände und eine Kapazität in der Schaltung des Negativ-Impedanzkonverters benötigt.

Die Erfindung wird anhand eines Prinzipschaltbildes und eines Ausführungsbeispiels näher erläutert.

Es zeigt:

Fig. 1 ein Prinzipschaltbild der Erfindung
Fig. 2 ein Ausführungsbeispiel der Erfindung

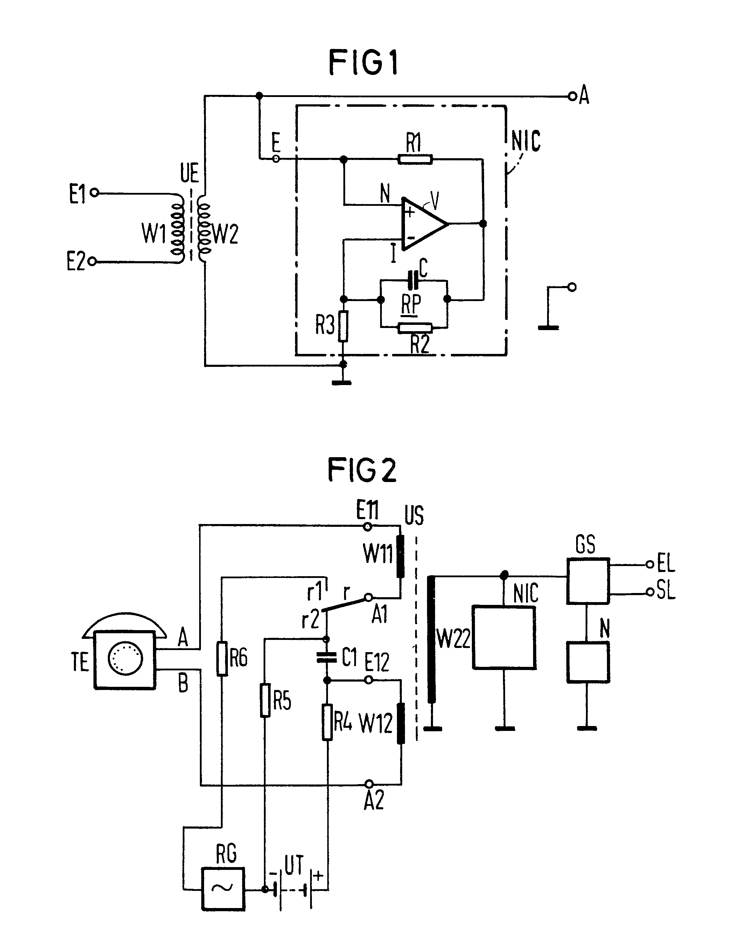

Ein Übertrager UE in Fig. 1 besitzt eine Primärwicklung W1 mit den Anschlußklemmen E1 und E2 und eine Sekundärwicklung W2, von der ein Anschluß an Masse geschaltet ist, während der zweite Anschluß an eine Ausgangsklemme A geschaltet ist. Die Induktivität der Sekundärwicklung wird im folgenden mit $L_{W2}$, der ohmsche Widerstand der Sekundärwicklung wird mit $R_{W2}$ bezeichnet. Parallel zur Sekundärwicklung W2 ist ein Negativ-Impedanzkonverters NIC geschaltet. Der Eingang E des Negativ-Impedanzkonverters ist mit der Ausgangsklemme A verbunden, der zweite Anschluß des Negativ-Impedanzkonverters NIC ist mit den Bezugspotential Masse und damit mit dem anderen Anschluß der Sekundärwicklung W2 verbunden. Der Negativ-Impedanzkonverter besteht im wesentlichen aus einem Verstärker V, der einen nichtinvertierenden und einen invertierenden Eingang besitzt. Der Eingang E des Negativ-Impedanzkonverters NIC ist mit dem nichtinvertierenden Eingang N des Verstärkers V verbunden. Der Ausgang des Verstärkers V ist über einen ersten ohmschen Widerstand R1 mit dem nichtinvertierenden Eingang N verbunden. Außerdem ist der Ausgang des Verstärkers V über eine Parallelschaltung eines Kondensators C und eines zweiten ohmschen Widerstandes R2 mit dem invertierenden Eingang I verbunden. Die Parallelschaltung von C und R2 ist mit RP bezeichnet. Der invertierende Eingang I ist über einen dritten ohmschen Widerstand R3 mit dem Bezugspotential Masse und hierüber mit dem anderen Anschluß der Sekundärwicklung W2 verbunden.

Zunächst wird die Funktion des Negativ-Impedanzkonverters kurz erläutert. Im bereits einleitend erwähnten Buch "Halbleiter-Schaltungstechnik", 3. Auflage, Seite 255 bis 258 ist ein Negativ-Impedanzkonverter zur Erzeugung negativer ohmscher Widerstände beschrieben.

Für den Eingangswiderstand am Anschlußpunkt E des Negativ-Impedanzkonverters NIC gilt:

$$R_E = U_E : I_E = - \frac{R1 \cdot R3}{RP} , \quad U_E, I_E - \text{Spannung, Strom an E}$$

für RP gilt im Ausführungsbeispiel:

$$RP = \frac{R2 \cdot \frac{1}{j\omega C}}{R2 + \frac{1}{j\omega C}}$$

mit der Kreisfrequenz $\omega = 2\pi f$, (f = Frequenz).
Damit ergibt sich für den Eingangswiderstand

$$R_E = - \frac{R1 \cdot R3}{R2} (1 + j\, C R2)$$

Diese Gleichung stellt die Reihenschaltung eines negativen ohmschen Widerstandes $R_N$ und einer negativen Induktivität $L_N$ dar.
Hieraus läßt sich für den negativen ohmschen Widerstand $R_N$ und die negative Induktivität $L_N$ angeben:

$$R_N = - \frac{R1 \cdot R3}{R2}$$

0035180

$$L_N = - R1 \cdot R2 \cdot C$$

Um die Stabilität der Schaltung zu gewährleisten, muß der auf den nichtinvertierenden Eingang N des Verstärkers V mitgekoppelte Spannungsteil kleiner als der auf den invertierenden Eingang I des Verstärkers V gegengekoppelte Spannungsteil sein. Die aus der Parallelschaltung des Negativ-Impedanzkonverters NIC und der Sekundärwicklung W2 des Übertragers UE resultierende Induktivität und der resultierende Widerstand müssen positiv sein. Hieraus lassen sich folgende Bedinungen für die Stabilität der Schaltung herleiten:

$$|R_{W2}| < |R_N| \,, \quad |L_{W2}| < |L_N|$$

($L_{W2}$ = Induktivität der Sekundärwicklung; $R_{W2}$ = ohmscher Widerstand der Sekundärwicklung W2)

Die resultierende Induktivität L ergibt sich aus der Parallelschaltung der Induktivität $L_N$ Negativ-Impedanzkonverters.

$$L = \frac{-L_{W2} \cdot L_N}{L_{W2} - L_N}$$

Bei einem Übersetzungsverhältnis von u = W1 : W2 = 1 des Übertragers UE entspricht diese Induktivität L der zwischen den Anschlußklemmen E1 und E2 der Primärwicklung W1 liegenden Induktivität, die bei Vernachlässigung der Streuinduktivitäten der Querinduktivität entspricht. Ist das Übersetzungsverhältnis u ungleich 1, so wird die Induktivität L mit dem Quadrat des Übersetzungsverhältnisses auf die Primärseite transformiert. Unter der Berücksichtigung des Übersetzungsverhältnisses kann die negative Induktivität natürlich ebenfalls der Primärwicklung oder einer zusätzlichen

80 P 6536 E

Wicklung parallel geschaltet werden. Entscheidend ist es, welche Wicklung potentialfrei gehalten werden soll. Die Streuinduktivitäten sind bei den Betrachtungen unberücksichtigt geblieben, da sie für die Erfindung unwesentlich sind.

Das Ausführungsbeispiel Fig. 2 zeigt die Anwendung der Erfindung in einer Telefon-Teilnehmerstation. Für die Erfindung unwesentliche Details sind in dieser Darstellung fortgeblasen.

In dieser Teilnehmerschaltung ist ein Telefonaparat TE über eine Teilnehmerleitung mit zwei Adern A und B mit der Primärwicklung eines Speiseübertragers US in der Amtsvermittlung verbunden. Die Primärwicklung besteht aus zwei Wicklungshälften W11 und W12, die über einen Umschaltkontakt r und einem Kondensator C1 in Serie geschaltet sind. Die Teilnehmerleitung A ist hierbei am Anschluß E11 der Wicklung W11 angeschaltet. Der zweite Wicklungsanschluß A1 der Wicklung W11 ist mit dem Umschaltkontakt r verbunden. In der dargestellten Stellung des Umschaltkontaktes r ist der Wicklungsanschluß A1 der ersten Wicklungshälfte W11 über den Umschaltkontakt r, den Kontaktanschluß r2 und den Kondensator C1 mit dem Wicklungsanschluß E12 der zweiten Wicklungshälfte W12 verbunden. Der Kontaktanschluß r2 ist über einen Widerstand R5 mit dem Minuspol einer Versorgungsspannungsquelle UT verbunden. Der Wicklungsanschluß E12 der zweiten Wicklungshälfte W12 ist über einen Widerstand R4 mit dem Pluspol der Versorgungsspannungsquelle $U_T$ verbunden. In der anderen Stellung des Umschaltkontaktes r wird der Anschluß A1 der Wicklungshälfte W11 über den Kontaktanschluß r1 und über einen Widerstand R6 an einen am Minuspol der Versorgungsspannungsquelle UT angeschlossenen Rufsignalgenerator RG angeschaltet. Der zweite Anschluß A2 der
Wicklungshälfte W12 ist mit der B-Ader verbunden.
Der Sekundärwicklung W22 ist der Negativ-Impedanzkonverter NIC parallel geschaltet. Jeweils ein Anschluß
der Sekundärwicklung und des Negativ-Impedanzkonverters NIC ist an Masse geschaltet. Über eine Gabelschaltung GS mit einer daran angeschlossenen Nachbildung N werden die ankommenden Gespräche auf der
Empfangsleitung EL von den abgehenden Gesprächen auf
der Sendeleitung SL getrennt.

Bei dieser Schaltung fließen über die Primärwicklung
cirka 90 mA Gleichstrom, ihre Wicklungsinduktivität
muß mindestens o,7 H betragen. Durch den Einsatz des
Negativ-Impedanzkonverters NIC ist ein Übertrager mit
einer Induktivität der Primärwicklung von beispielsweise 0,2 H verwendbar.

In der vorstehend beschriebenen Schaltung wird über
den Speiseübertrager US der Telefonaparat TE mit
Gleichspannung versorgt. Durch die galvanische Entkopplung zwischen Primär- und Sekundärwicklung dient
er ebenfalls zur Unterdrückung von Gleichtaktspannungen
auf den Teilnehmerleitungen A, B.

Durch die Vermittlung wird der Schaltkontakt r mit dem
Kontaktanschluß r1 verbunden. Dadurch ist der Rufgenerator RG über den Widerstand R6, die Wicklungshälfte W11,
über die A-Ader mit dem Telefonaparat TE verbunden, und
der Stromkreis ist über die B-Ader, die Wicklung W12
den Widerstand R4 und die Versorgungsspannungsquelle $U_T$
geschlossen.

Ist der Teilnehmer angerufen worden und wird der
Hörer des Telefonaparates TE abgehoben, so wird dies der Vermittlung von einem nicht dargestellten Schleifenschlußdetektor signalisiert. Diese betätigt den Umschaltkontakt r, schaltet damit den Rufsignalgenerator RG, der das Klingelzeichen abgegeben hat, ab. Der Umschaltkontakt r ist jetzt mit dem Kontaktanschluß r2 verbunden und der Gleichstromkreis ist über den Minuspol der Gleichspannungsversorgungsquelle UT über den Widerstand R5, den Schaltkontakt r, die Wicklung W11, die A-Ader, den Telefonaparat TE, die B-Ader, die Wicklung W12 und der Widerstand R4 geschlossen. Wechselspannungsmäßig sind jetzt die Primärwicklungen W11 und W12 über den Umschaltkontakt r und den Kondensator C1 in Reihe geschaltet. Die Verbindung für Sprachsignale über den Übertrager US ist damit hergestellt. Die Trennung der Gesprächsrichtungen erfolgt durch die Gabelschaltung GS auf der Sekundärseite des Übertragers UT.

4 Patentansprüche

2 Figuren

<u>Patentansprüche</u>

1. Schaltungsanordnung zur Erhöhung der Induktivität eines Übertragers, d a d u r c h   g e k e n n - z e i c h n e t,  daß parallel zu einer Wicklung (W1, W2) des Übertragers (UE) eine negative Induktivität geschaltet ist.

2. Schaltungsanordnung nach Anspruch 1,  d a d u r c h   g e k e n n z e i c h n e t,  daß parallel zu einer Wicklung (W1, W2) des Übertragers (UE) als negative Induktivität ein Negativ-Impedanzkonverter (NIC) geschaltet ist.

3. Schaltungsanordnung nach Anspruch 2,  d a d u r c h   g e k e n n z e i c h n e t,  daß ein Negativ-Impedanz- konverter (NIC) vorgesehen ist, dessen Eingang (E) auf den nichtinvertierenden Eingang (N) eines Verstär- kers (V) geführt ist, daß der Ausgang des Verstärkers (V) über einen ersten ohmschen Widerstand (R1) mit seinem nichtinvertierenden Eingang (N) verbunden ist und über eine Parallelschaltung eines Kondensators (C) und eines zweiten ohmschen Widerstandes (R2) mit seinem invertierenden Eingang (I) verbunden ist und daß der invertierende Eingang (I) über einen dritten ohmschen Widerstand (R3) an ein Bezugspotential (Masse) geschaltet ist.

4. Schaltungsanordnung nach einem der Ansprüche 1 bis 3, d a d u r c h   g e k e n n z e i c h n e t,  daß eine negative Induktivität parallel zur vermittlungsseitigen Wicklung (W22) eines Speiseübertragers (US) in einer Fernsprech-Teilnehmerschaltung geschaltet ist.

# FIG 1

# FIG 2